# NOUVEAU FASCICULE DE BREVET EUROPEEN

(11) **EP 0 399 868 B2**
(45) Date de publication et mention de la décision concernant l'opposition: **13.12.2000**
(45) Mention de la délivrance du brevet: 12.10.1994
(21) Numéro de dépôt: 90401253.1
(22) Date de dépôt: 11.05.1990
(51) Int. Cl.: G06K 19/077

(54) **Procédé de fabrication d'une carte à puce**
Herstellungsverfahren einer Chipkarte
Manufacturing process of a chip card

(30) Priorité: 26.05.1989 FR 8906908; 02.03.1990 FR 9002624
(43) Date de publication de la demande: 28.11.1990
(60) Demande divisionnaire: 94104315.0
(73) Titulaire: Sempac SA, 6330 Cham (CH)
(72) Inventeur: Lemaire, Gérard, F-54000 Nancy (FR); Lemaire Philippe, F-54000 Nancy (FR)
(74) Mandataire: Falk, Urs, Dr.

(56) Documents cités:
- EP-A- 0 246 973
- EP-A- 0 254 640
- EP-A- 0 277 854
- EP-A- 0 340 100
- US-A- 4 470 786
- PATENT ABSTRACTS OF JAPAN, vol. 11, no. 296 (M-627)(2743), 25 septembre 1987 & JP-A-62 90 213

## Description

La présente invention concerne un procédé de fabrication de cartes communément appelées "cartes à puce".

Ces cartes de conception récente, sont des cartes de crédit comportant un module électronique mettant en oeuvre un composant électronique performant dit puce électronique.

Le problème principal qui se pose dans la conception de telles cartes concerne la mise en place et la fixation du module électronique dans la carte en matière plastique.

A l'heure actuelle, la plupart des cartes à puces sont fabriquées en découpant tout d'abord la carte en matière plastique à partir d'une planche ou en moulant ladite carte en matière plastique.

Cette carte en matière plastique est conformée avec une cavité dans laquelle on positionne et colle le module électronique.

Le document EP 0 254 640 décrit un tel procédé de fabrication de carte à puce. Dans ce document, il est prévu suivant une première forme de réalisation de former une cavité débouchant sur les deux faces de la carte en matière plastique, le module électronique est positionné avec ses contacts affleurant sur une face de la carte et l'on remplit la cavité de colle pour fixer ledit module. Il est alors relativement protégé par la colle mais il demeure possible qu'il soit soumis à des agressions externes risquant d'altérer sa fiabilité.

Afin de mieux protéger le module électronique, une seconde forme de réalisation consiste à former une cavité non débouchante. Le module n'est alors pas accessible au verso de la carte. Cette forme de réalisation est toutefois très complexe à mettre en oeuvre car les cotes doivent toutes être strictement respectées sous peine d'obtenir une carte dont les contacts ne sont pas dans le plan de la carte en matière plastique.

Afin de pallier ces inconvénients, on a cherché à obtenir une carte à puce en surmoulant le corps de carte autour du module électronique. A cet effet, le module électronique est positionné dans un moule et l'on injecte la matière plastique destinée à former la carte en matière plastique.

Un tel procédé est par exemple décrit dans le document japonais JP-A-60 217 491 ou dans le document européen 0 277 854.

Ces procédés ne donnent pas satisfaction car le maintien en position du module électronique dans le moule n'est pas totalement assuré.

Le document japonais prévoit la mise en place du module en insérant un téton qu'il porte dans une cavité du moule. La mise en oeuvre d'une telle solution ne permet pas d'obtenir une carte de bonne qualité du fait que la matière plastique injectée sous une pression d'environ 700 Kg/cm² déplace ledit module.

Le brevet européen 0 277 854 cherche à améliorer cette disposition par la mise en oeuvre d'un système à dépression afin d'assurer par aspiration le maintien en position du module au cours de l'injection. Cette aspiration est de plus prévue afin de plaquer les contacts dudit module contre la face interne du moule.

Cette disposition n'est pas très efficace car l'on peut difficilement avec une pompe à vide maintenir le module à l'encontre de la pression que lui applique la matière injectée.

Ce brevet européen prévoit une seconde disposition dans laquelle le module électronique est maintenu par un plateau supporté par des ressorts.

Par une telle disposition, il est prévu, qu'au cours du moulage la matière entoure tout d'abord le module avant de pousser ledit plateau à l'encontre des ressorts afin de remplir la totalité de la cavité du moule.

Ceci est tout à fait illusoire car la matière sous pression agira dès le début de l'injection sur le plateau et le module ne sera plus maintenu . Ces mises en oeuvre ne permettent pas d'obtenir des cartes dont le module est parfaitement positionné et, de plus, la matière parvient à s'infiltrer entre les contacts et la paroi du moule ce qui souille lesdits contacts et oblige à prévoir une phase de nettoyage de ces contacts. Bien entendu, ce nettoyage grève très gravement le prix de revient de la carte à puce ainsi fabriquée.

Le module décrit et mis en oeuvre dans ce brevet est formé à partir d'une plaque en un matériau isolant sur une face de laquelle on effectue un dépôt métallique afin de former les contacts.

Sur la face opposée, on fixe et câble la puce électronique puis on l'enrobe de résine.

Un tel module est malaise à mettre en oeuvre car la résine se solidarise mal avec la plaque en matériau isolant.

De même, la matière plastique utilisée pour former le corps de carte s'accroche mal à la plaque.

Il s'ensuit que si la carte à puce fabriquée avec un tel module est pliée, il se produit une désolidarisation de ladite plaque en matériau isolant de la carte en matière plastique et même de la résine ce qui rend la carte totalement inutilisable.

D'autre part dans ce même brevet européen 0 277 854, il est précisé que pour obtenir un bon ancrage du module dans la matière moulée, il faut donner à l'enrobage en résine une forme telle qu'il présente une contre-dépouille. Il s'avère cependant que cette disposition est très défavorable. En effet cette contre-dépouille définit un volume en forme de coin dans lequel vient s'insérer la matière plastique lors de l'injection ; la matière plastique injectée sous haute pression exerce alors des efforts qui ont pour effet de séparer l'un de l'autre la bande métallique et l'ensemble constitué par le composant électronique et son enrobage. On ne peut donc pas comme dans le brevet EP 0 277 854 compter sur la forme donnée à l'enrobage de résine pour assurer l'accrochage du module dans la carte en matière plastique et il est même préférable d'éviter de donner à l'enrobage de résine la forme décrite dans ce brevet et, de préférence, lui donner une forme inverse de façon que les forces exercées sur l'enrobage de résine par la matière injectée sous haute pression aient tendance à le plaquer contre la bande métallique.

La présente invention cherche à pallier ces différents inconvénients en proposant un procédé de fabrication de cartes à puce d'un prix de revient largement inférieur au prix actuel et permettant d'obtenir des cartes parfaites.

A cet effet, l'invention propose un procédé de fabrication d'une carte à puce conformément à la revendication 1.

Afin que le pincement soit possible, le module électronique et les moyens de positionnement prévus dans le moule ont des dimensions telles que leur hauteur totale soit égale à celle de la cavité du moule.

L'utilisation d'un module électronique fabriqué à partir d'une bande métallique présente l'avantage de permettre la mise en oeuvre de moyens permettant d'assurer convenablement la solidarisation tant de la résine sur la bande que de la matière plastique sur le module.

A cet effet:
- on forme des crevés dans la bande métallique afin d'assurer l'accrochage de la résine,
- la bande métallique présente une bordure en décrochement par rapport aux contacts;
- le bord est cambré pour former le décrochement.

Afin d'éviter une séparation de la bande métallique et de l'enrobage de résine entourant le composant électronique, on donne de préférence audit enrobage une forme biseautée telle que les forces exercées sur lui par la matière injectée aient tendance à l'appliquer contre la bande métallique comportant les contacts.

Avec l'invention on peut également résoudre de manière économique le problème de la décoration des cartes à puce.

Selon une mise en oeuvre de l'invention,
- le module électronique présente sur sa face opposée à celle portant les contacts une jupe crénelée;
- des ouvertures sont prévues dans la jupe;
- le moule utilisé présente des tétons sur lesquels on engage le module par ses ouvertures jusqu'à ce que les faces d'extrémités des portions de la jupe reposent sur le fond dudit moule.

L'invention sera mieux comprise et d'autres caractéristiques et avantages de celle-ci ressortiront de la description qui va suivre en référence au dessin sur lequel :
La figure 1 est une vue en coupe d'une première forme de réalisation de la partie centrale du module électronique;
La figure 2 est une vue partielle à échelle différente;
La figure 2a montre un détail de la figure 2;
La figure 3 est une vue en coupe d'une seconde forme de réalisation de la partie centrale du module électronique;
La figure 4 est une vue de dessous d'une forme de réalisation du module électronique;
La figure 5 est une vue en coupe selon la ligne V-V de la figure 4;
La figure 6 est une vue en coupe d'une première installation de surmoulage;
La figure 7 est une vue du recto de la carte obtenue par le procédé, objet de l'invention;
La figure 8 est un vue du verso de la carte obtenue par le procédé, objet de l'invention.

La première étape du procédé selon l'invention consiste à réaliser le module électronique que doit porter la carte.

A cet effet, on utilise une des techniques d'assemblage des composants électroniques connues pour la réalisation de boîtiers plastiques du type pour composants de puissance ou pour microprocesseur.

Pour ce faire, on met en oeuvre une bande métallique 19, généralement en cuivre, qui est prédécoupée et préformée afin de former par découpage de tronçons, les contacts 10 nécessaires. Une telle bande est de manière usuelle en cuivre ou alliage cuivre-berylium argenté ou doré.

Sur cette bande métallique 19, on soude la puce électronique 12 par exemple à l'aide de colle conductrice 13 et on câble par soudure thermo-sonique.

Le circuit électronique ainsi préparé sur chaque tronçon de ladite bande 19 est enrobé d'une résine 14 après avoir été positionné dans un moule à cet effet.

Cet enrobage par la résine 14 permet de protéger efficacement la puce 12 et d'éviter toute détérioration du câblage.

La résine 14 utilisée est de préférence une résine, dite de qualité électronique, c'est-à-dire une résine ne comportant pas de constituants tels que le chlore ou le phosphore risquant de détruire la puce. A cet effet, on choisira par exemple une résine époxy ou des silicones.

Cependant pour des composants dont la durée de vie est limitée dans le temps, comme par exemple les cartes de téléphone, on pourra, en protégeant la puce par un vernis, utiliser une résine thermoplastique adaptée ce qui permet de réduire les coûts de fabrication tout en augmentant les cadences car la mise en oeuvre d'une telle résine thermoplastique est beaucoup plus aisée.

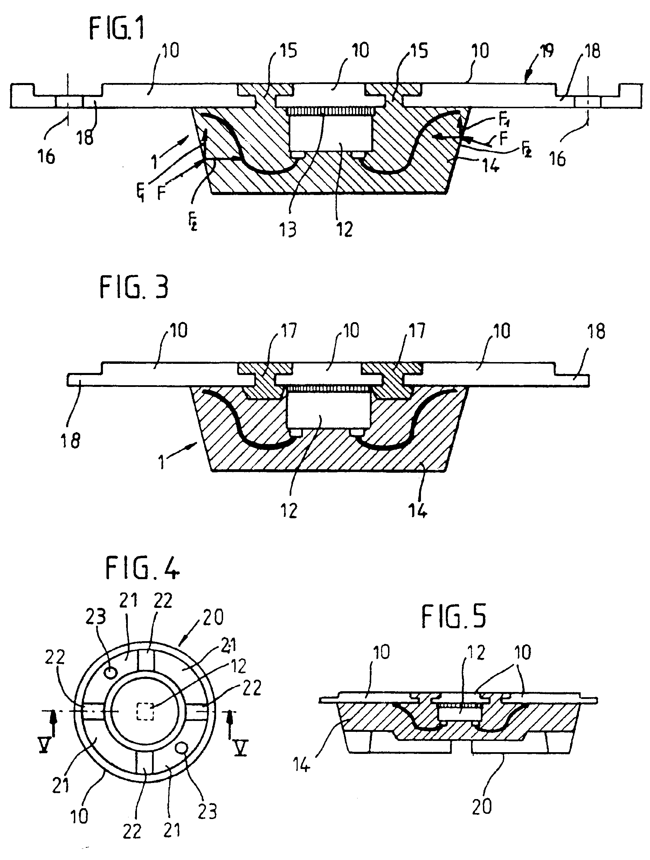

Comme on peut le voir à la figure 1, la résine 14 est admise à remplir les espaces libres 15 entre les contacts 10 afin d'assurer leur liaison mécanique et leur isolement électrique en même temps que la tenue mécanique du module. Les espaces 15 sont prévus avec une surface agrandie sur la face opposée à la puce 12 afin d'assurer un accrochage parfait de la résine 14 avec la bande métallique 19.

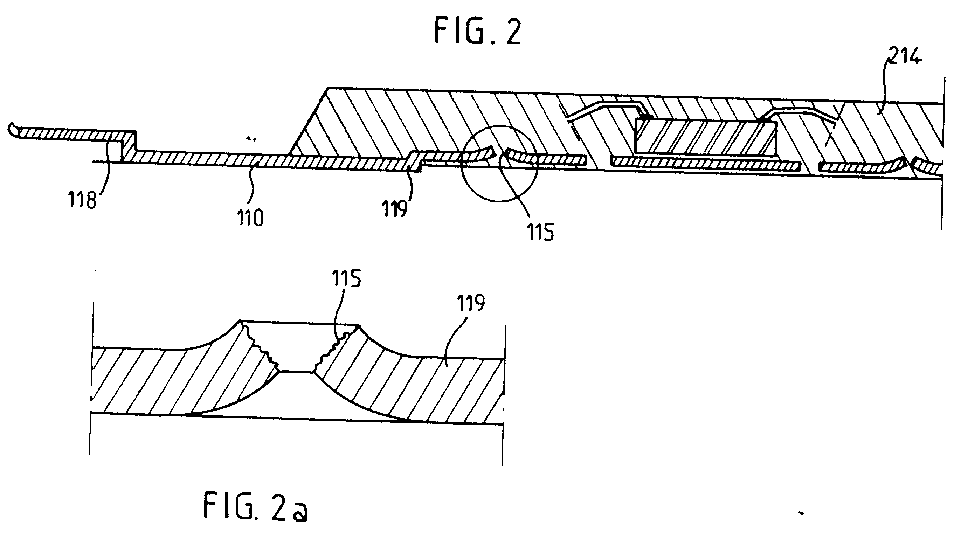

La figure 2 représente une variante de réalisation dans laquelle la bande métallique 119 utilisée est peu épaisse. Dans ce cas, on réalise des crevés 115 de place en place afin d'assurer l'accrochage de la résine 114 et de la bande métallique 119.

Le module électronique 1 nécessaire à la carte que l'on veut fabriquer est alors obtenu en découpant la bande 19 en 16 afin d'en obtenir un tronçon présentant les contacts 10.

Une des difficultés rencontrées dans cette réalisation concerne le fait qu'il est indispensable que la surface des contacts 10 à l'extérieur du module 1 soit parfaitement lisse et propre pour qu'ils assurent convenablement leur rôle dans la carte qui les comportera.

Ces difficultés sont particulièrement importantes lorsque l'espace entre les contacts est important ou lorsque les séparations desdits contacts sont trop éloignées de la zone de serrage du moule utilisé pour l'enrobage ou encore lorsque les liaisons métalliques entre les contacts sont trop fines et ne peuvent être convenablement plaquées par la résine contre le fond du moule.

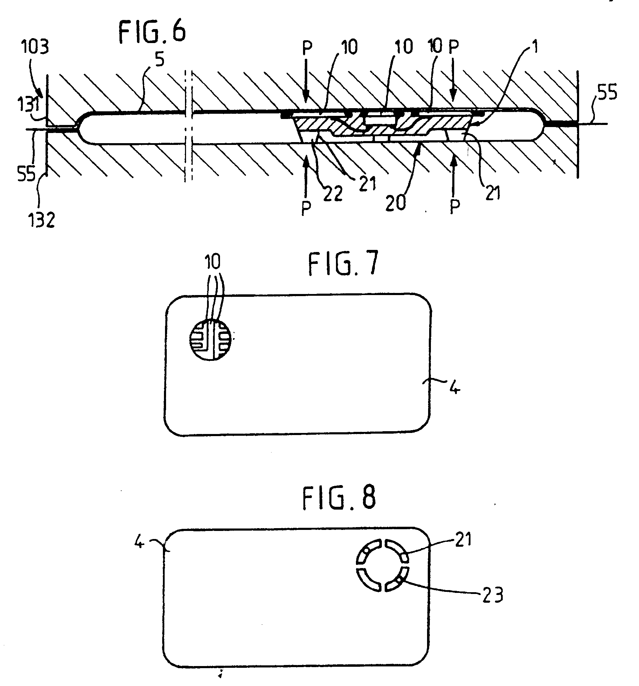

Lorsque cela est possible, on prévoit un nouveau dessin des contacts afin de résoudre ces difficultés et dans le cas inverse, on procède comme visible à la figure 3.

Dans une première étape, on forme des pions 17 de résine sur la bande métallique 19 afin d'assurer la liaison mécanique entre les contacts 10, puis, on effectue le collage et le câblage de la puce 12 après avoir si nécessaire nettoyé la bande 19 dans les zones nécessaires.

Lors de l'enrobage par la résine 14, celle-ci se solidarise auxdits pions 17 pour former le module électronique 1 recherché.

Comme on peut le voir sur les figures 1 à 3, la bande métallique 19, 119 est conformée de manière telle qu'après avoir effectué les découpes de celle-ci en 16 la bordure 18, 118 soit en décrochement par rapport aux contacts 10, 110. Dans le cas de la figure 2, la bande 119 présentera un bord 118 cambré à cet effet.

Cette conformation des bords 18, 118 est utile comme il sera expliqué plus loin, pour assurer une bonne solidarisation du module et de la carte qui le comporte.

Le bloc de résine 14 est prévu avec une forme biseautée en étant plus large près des contacts qu'à l'extrémité qui en est éloignée. Ainsi, comme visible à la figure 1, les forces F exercées par la matière plastique sur ledit bloc 14, lors du remplissage du moule, se décomposent en des forces verticales F1 dirigées vers les contacts 10 et en des forces horizontales F2 dirigées vers l'intérieur du bloc de résine.

Les forces horizontales F2, toutes opposées deux à deux s'annulent tandis que les forces F1 créent une force résultante tendant à plaquer la résine 14 sur les contacts 10 et à déplacer le module vers le haut de la figure 1. L'utilité de cette force résultante sera reprise plus loin.

Les figures 4 et 5 montrent en détail la forme donnée, selon un premier mode de réalisation, au bloc de résine 14 et donc au module 1. Cette forme est spécialement étudiée pour permettre la mise en oeuvre dans de bonnes conditions du procédé suivant l'invention.

Dans cette forme de réalisation, le bloc de résine 14 de forme générale tronconique présente sur sa face opposée à celle portant les contacts 10 une jupe crénelée 20. Dans l'exemple représenté, ladite jupe 20 et découpée en quatre portions 21 par des canaux 22. Ladite jupe 20 présente des ouvertures 23 destinées au positionnement du module 1 dans le moule.

Afin de réaliser le surmoulage du module 1 pour former la carte à puce recherchée, on positionne celui-ci comme visible à la figure 6 dans un moule 103. Le moule 103 de cette première forme de mise en oeuvre, comporte de manière connue en soi deux coquilles 131 et 132 ; l'une des coquilles, ici la coquille inférieure 132, possède des ergots non représentés sur lesquels on engage le module 1.

Le module 1 est engagé sur les tétons par les ouvertures 23 jusqu'à ce que les faces d'extrémités de portions 21 de la jupe 20 reposent sur le fond de la coquille 132 puis l'on positionne la coquille 131 afin de fermer le moule 103.

Cette opération peut être effectuée de manière avantageuse par un outil approprié prenant les modules positionnés sur une table de report lorsque l'on utilise un moule à plusieurs empreintes.

Suivant l'invention, le module 1 est pincé entre les coquilles du moule 103 par l'application d'une pression P sur ledit moule, comme montré schématiquement par les flèches P de la figure 6, dans la zone où se trouve le module.

A cet effet, la jupe 20 est dimensionnée de manière telle que lorsque le module 1 est dans le moule 103, il est en contact avec la coquille 131 par ses contacts 10 et avec la coquille 132 par les extrémités des portions de jupe 20 qui forment des zones d'application privilégiées de l'effort de pression.

Ainsi, lorsque l'on applique la pression, le module 1 est fortement pincé ce qui assure un placage efficace des contacts 10 contre la face interne du moule 103. Ledit placage étant encore amélioré par la résultante des forces F1 dirigées vers les contacts qu'exerce la matière plastique sur le bloc de résine.

De ce fait, la matière plastique lors de son injection ne peut ni déplacer le module 1 et détruire son positionnement, ni s'infiltrer entre le module et la coquille supérieure pour souiller les contacts.

Au cours de l'opération de surmoulage, les canaux 22 de séparation de la jupe 20 assurent le passage de la matière plastique injectée pour le remplissage de la zone intérieure de la jupe 20. Le bord 18, 18′ prévu en décrochement par rapport au plan des contacts 10 permet le passage de la matière autour des bords du module 1 afin d'assurer un accrochage parfait dudit module dans la carte plastique.

Les figures 7 et 8 montrent l'aspect recto et verso de la carte 4 ainsi obtenue.

On voit sur la figure 7 que les contacts 10 sont visibles à la surface de ladite carte 4 afin d'être opérationnels lorsque l'on désire utiliser cette carte.

Au verso de ladite carte 4, on voit les faces d'extrémités des portions 21 de jupe ainsi que les ouvertures de centrage 23.

Le module 1 représenté aux figures est un module de section ronde, il est bien entendu que l'on ne sortira pas du cadre de la présente invention en créant un module d'une autre section. On pourra de même adapter à volonté la forme, le nombre et la répartition des ouvertures 23.

La carte 4 peut si désiré être imprimée afin de servir de support publicitaire ou de support d'informations diverses telles que, par exemple, le mode d'emploi de cette carte.

A cet effet, l'invention propose de réaliser cette impression avec un faible coût en utilisant la méthode d'impression dite par transfert d'image.

Comme visible à la figure 6, un film 5 est mis en place dans l'une au moins des coquilles du moule 103. Ce film porte sur sa face tournée vers l'intérieur dudit moule l'image à transférer sur la carte. Le film 5 est prévu avec des portions 55 dépassant du moule et portant des repères optiques permettant d'assurer son positionnement.

Le film de transfert peut-être prévu avec une zone incolore afin de ne pas imprimer les contacts.

On peut également utiliser un film de transfert dont l'image est adaptée à se coller sur la matière plastique mais pas sur les pièces métalliques.

Ainsi, lorsque l'on retire le film à l'issue du moulage, l'image se découpe d'elle-même afin d'épouser le contour des contacts. Cette technique est intéressante dans le cas ou le module est de forme telle que des portions de matière plastique sont disposées entre les contacts car l'on pourra alors décorer aisément ces portions ce qui améliore l'esthétique de la carte. On peut décorer aussi la carte au cours du moulage au recto et/ou au verso par une ou deux étiquettes placés dans le moule.

## Revendications

1. Procédé de fabrication d'une carte à puce (4) en matière plastique comportant un module électronique (1) contenant la puce enrobée d'une résine (14) et ayant des contacts (10) disposés sur la carte, au cours dudit procédé la carte est moulée dans un moule (103) à l'intérieur duquel est positionné le module électronique (1) afin que celui-ci se trouve noyé sur sa face arrière et sa périphérie dans la matière plastique dont est constituée la carte, au cours dudit procès on forme le module (1) en réalisant lesdits contacts (10) sous la forme d'un leadframe à partir d'une bande métallique (19) prédécoupée et préformée, on soude et câble la puce électronique (12) sur ledit leadframe, on enrobe la puce avec la résine (14), on place le module dans ledit moule qui est équipé avec des moyens de positionnement et de blocage pour le module, les contacts faisant face à la paroi interne du moule, et on applique une pression P fermant le moule (103), caracterisée en ce que la hauteur du module est égale à la hauteur de la cavité dudit moule de telle manière qu'en fermant le moule on pince fortement le module électronique (1) entre les deux coquilles du moule afin d'assurer son maintien dans les moyens de positionnement et de blocage et le placage de ses contacts (10) contre la paroi interne du moule.

2. Procédé selon la revendication 1, caractérisé en ce que la résine (14) a une forme biseautée en étant plus large près des contacts (10) qu'à l'extrémité qui en est éloignée; de telle sorte que l'on utilise l'effet de pression de la matière plastique sur les formes latérales du module pour créer une force dont les résultantes horizontales s'annulent deux à deux tandis que la résultante verticale, non nulle, contribue à exercer la pression P de placage des contacts du module contre la coquille du moule.

3. Procédé selon l'une quelconque des revendications précédentes, caractérisé en ce que l'on forme des crevés (115) dans la bande métallique (119) afin d'assurer l'accrochage de la résine (114).

4. Procédé selon l'une quelconque des revendications précédentes , caractérisé en ce que la bande métallique (19, 119) présente une bordure (18, 118) en décrochement par rapport aux contacts (10, 110).

5. Procédé selon la revendication 4, caractérisé en ce que le bord (118) est cambré pour former le décrochement.

6. Procédé selon l'une quelconque des revendications précédentes, caractérisé en ce que l'on forme des pions (17) de résine sur la bande métallique avant de coller et câbler la puce électronique (12).

7. Procédé selon l'une quelconque des revendications précédentes, caractérisé en ce que le module électronique (1) présente sur sa face opposée à celle portant les contacts (10) une jupe crénelée (20).

8. Procédé selon la revendication 7, caractérisé en ce que des ouvertures (23) sont prévues dans la jupe (20).

9. Procédé selon la revendication 8, caractérisé en ce que le moule (103) utilisé présente des tétons sur lesquels on engage le module (1) par ses ouvertures (23) jusqu'à ce que les faces d'extrémités des portions (21) de la jupe (20) reposent sur le fond dudit moule.

## Claims

1. Process for manufacturing a chip card of plastic material comprising an electronic module (1) containing the electronic chip (12) embedded in resin (14) and having electrical contacts (10) disposed on the card, the process involving moulding the card in a mould (103) inside which the electronic modul (1) is positioned so that over its rear face and its peripheral edge it is embedded in the plastic material constituting the card, the process involving forming the module (1) by making the named contacts (10) in the form of a leadframe by starting from a precut and preformed metal strip (19), bonding and wiring the electronic chip (12) on the named leadframe, encapsulating the chip in the resin (14), placing the module in the mould which has positioning and blocking means for the module, the contacts facing the inner wall of the mould, applying a pressure P by closing the mould (103), characterized in that the height of the module equals the height of the cavity of the mould such that when closing the mould the electronic module (1) is tightly squeezed between the two mould shells in order to ensure that it is held in the positioning and blocking means and that its contacts (10) are pressed against the inner wall of the mould.

2. Process according to claim 1, characterised in that the resin (14) has a bevelled shape, being wider near the contacts (10) than at the end remote therefrom; with the result that the pressure exerted by the plastic on the lateral forms of the module is used to create a force whose horizontal resultants cancel each other out, whilst the vertical resultant, having a positive value, helps to exert a pressure P for pressing the contacts of the module against the mould shell.

3. Process according to any of the preceding claims, characterised in that recesses (115) are made in the metal strip (119) so as to enable the resin (114) to stick.

4. Process according to any of the preceding claims, characterised in that the metal strip (19, 119) exhibits a border (18, 118) which is out of alignment with respect to the contacts (10, 110).

5. Process according to claim 4, characterised in that the edge (118) is raised to form the misalignment.

6. Process according to any of the preceding claims, characterised in that small resin knobs (17) are formed on the metal strip before joining and wiring the electronic chip (12).

7. Process according to any of the preceding claims, characterised in that the electronic module (1) exhibits a crenellated skirt (20) on its opposite face to that carrying the contacts (10).

8. Process according to claim 7, characterised in that apertures (23) are provided in the skirt (20).

9. Process according to claim 8, characterised in that the mould (103) used exhibits lugs on which the module (1) is engaged by its apertures (23) until the end faces of the portions (21) of the skirt (20) rest against the bottom of said mould.

## Patentansprüche

1. Herstellungsverfahren für eine Chipkarte (4) aus Plastikmaterial, die ein Elektronikmodul (1) aufweist, das den mit einem Kunststoff (14) umhüllten Chip enthält und auf der Karte angeordnete Kontakte (10) aufweist, bei welchem Verfahren die Karte in einer Form (103) gegossen wird, innerhalb der das Elektronikmodul (1) positioniert ist, so dass es auf seiner Rückseite und an seiner Peripherie in dem die Karte bildenden Material eingebettet wird, bei welchem Verfahren man das Modul (1) bildet, in dem man die genannten Kontakte (10) ausgehend von einem vorgeschnittenen und vorgeformten Metallband (19) in Form eines Leadframes realisiert, man den Elektronik-Chip (12) auf dem genannten Leadframe befestigt und verdrahtet, man den Chip mit dem Kunststoff umhüllt, man das Modul in der genannten Form plaziert, die mit Positionierungs- und Festhaltemitteln für das Elektronikmodul ausgestattet ist, wobei die Kontakte der Innenwand der Form gegenüberliegen, und man einen die Form schliessenden Druck P anlegt, dadurch gekennzeichnet, dass die Höhe des Moduls gleich der Höhe der Kavität der genannten Form ist, derart, dass man das Elektronikmodul (1) beim Schliessen der Form kräftig zwischen den beiden Formhälften einklemmt, um seinen Sitz in den Positionierungs- und Festhaltemitteln sowie das Anpressen seiner Kontakte (10) gegen die Innenwand der Form sicherzustellen.

2. Verfahren nach Anspruch 1, dadurch gekennzeichnet, dass der Kunststoff (14) eine seitlich abgeschrägte Gestalt aufweist, indem er auf der Seite der Kontakte (10) breiter ist als auf der von ihnen abgekehrten Seite, derart, dass man die Druckwirkung des Plastikmaterials auf die abgeschrägten Seiten des Moduls ausnützt, um eine Kraft zu erzeugen, deren horizontalen Komponenten sich gegenseitig aufheben, während deren vertikale, nicht verschwindende Komponente dazu beiträgt einen Druck P zum Anpressen der Kontakte des Moduls gegen die Innenwand der Form auszuüben.

3. Verfahren nach einem der vorangehenden Ansprüche, dadurch gekennzeichnet, dass man im Metallband (119) Vertiefungen (115) bildet, um die Haftung des Kunststoffes (114) zu gewährleisten.

4. Verfahren nach einem der vorangehenden Ansprüche, dadurch gekennzeichnet dass das Metallband (19, 119) einen in bezug auf die Kontakte (10, 110) abgesetzten Rand (18, 118) aufweist.

5. Verfahren nach Anspruch 4, dadurch gekennzeichnet, dass der Rand (118) gegenüber den Kontakten abgekröpft ist

6. Verfahren nach einem der vorangehenden Ansprüche, dadurch gekennzeichnet, dass man vor dem Befestigen und Verdrahten des Elektronik-Chips (12) Ansätze (17) aus Kunststoff auf dem Metallband formt.

7. Verfahren nach einem der vorangehenden Ansprüche, dadurch gekennzeichnet, dass das Elektronikmodul (1) auf seiner den Kontakten (10) gegenüberliegenden Seite einen gezackten Kragen (20) aufweist.

8. Verfahren nach Anspruch 7, dadurch gekennzeichnet, dass im Kragen (20) Oeffnungen (23) vorgesehen sind.

9. Verfahren nach Anspruch 8, dadurch gekennzeichnet, dass die verwendete Form (103) Passstifte aufweist, auf denen das Modul (1) mit seinen Oeffnungen (23) positioniert wird, bis es mit den vorstehenden Stirnseiten von Teilen (21) des Kragens (20) auf dem Grund der Form aufliegt.
